# EUROPÄISCHE PATENTSCHRIFT

(11) **EP 2 950 059 B1**
(45) Veröffentlichungstag und Bekanntmachung des Hinweises auf die Patenterteilung: **10.07.2019**
(21) Anmeldenummer: 15168974.2
(22) Anmeldetag: 22.05.2015
(51) Int. Cl.: H03H 7/38, H04B 3/52

(54) **ABSCHLUSSELEMENT FÜR FÜLLSTANDMESSGERÄT UND FÜLLSTANDMESSGERÄT**
CLOSING ELEMENT FOR FILL LEVEL MEASURING DEVICE AND FILL LEVEL MEASURING DEVICE
ÉLÉMENT DE FERMETURE POUR APPAREIL DE MESURE DU NIVEAU DE REMPLISSAGE ET APPAREIL DE MESURE DU NIVEAU DE REMPLISSAGE

(30) Priorität: 26.05.2014 DE 102014107393
(43) Veröffentlichungstag der Anmeldung: 02.12.2015
(73) Patentinhaber: Krohne S.A.S., 26103 Romans-sur-Isere Cedex (FR)
(72) Erfinder: Pichot, Vincent, 26100 Romans-sur Isère (FR)
(74) Vertreter: Gesthuysen Patent- und Rechtsanwälte

(56) Entgegenhaltungen:
- EP-A1- 2 711 673
- US-A- 4 035 748
- US-A1- 2010 007 441

## Beschreibung

Die Erfindung betrifft ein Abschlusselement für eine Leitervorrichtung eines nach dem Laufzeit-Verfahren arbeitenden Füllstandmessgeräts. Weiterhin betrifft die Erfindung ein nach dem Laufzeit-Verfahren arbeitendes Füllstandmessgerät mit einer mindestens aus einem Außenleiter und einem Innenleiter gebildeten Leitervorrichtung zum Führen von elektromagnetischen Signalen.

Bei einem Füllstandmessgerät, das nach dem Laufzeit-Verfahren arbeitet, wird das sogenannte TDR-Messprinzip (Time Domain Reflectometry) angewendet, indem die Laufzeit von entlang einer Leitervorrichtung geführten elektromagnetischen Signalen ausgewertet wird. Die Signale werden dabei entlang der Leitervorrichtung - bzw. insbesondere entlang mindestens einem der zwei die Leitervorrichtung bildenden Leitern - in Richtung der Oberfläche des Mediums, dessen Füllstand ermittelt werden soll, ausgesandt. Treffen die Signale auf die Oberfläche des Mediums, so werden sie dort teilweise reflektiert. Aus der Laufzeit zwischen dem Aussenden und dem Empfang der reflektierten Signale lässt sich dann der Füllstand des Mediums ermitteln. Der große Vorteil des Führens der Mikrowellensignale besteht darin, dass sich ändernde Umgebungsbedingungen (z. B. steigender oder ein fallender Umgebungsdruck, steigende oder fallende Temperatur) die Messgenauigkeit nicht beeinträchtigen und dass zudem die Laufzeit des Signals unabhängig von der Dielektrizitätszahl des Mediums ist.

Die Leiter verfügen zumeist über ein Befestigungsende, mit dem sie an einem Anschluss oder Flansch befestigt sind, und über ein freies, dem Medium zugewandtes Ende. Über den Anschluss sind die Leiter mit einer Elektronik verbunden, die die zu übertragenden Signale erzeugt und die reflektierten Signale empfängt und auswertet.

Bei den beschriebenen Füllstandmessgeräten existieren sogenannte "Totzonen", die Füllstandbereiche des Mediums beschreiben, in denen eine Messung nicht oder nur mit großer Ungenauigkeit möglich ist. Die Ursache für die "Totzonen" liegt in Impedanzsprüngen der für die Leitung der Signale verwenden Leiteranordnung, die sich durch die mechanische Konstruktion oder durch geometrische Gegebenheiten einstellen.

Dabei wird zwischen einer "obere Totzone" in dem Bereich, in dem die Leiteranordnung in den Behälter hineingeführt ist, und einer "unteren Totzone" am freien Ende unterschieden.

Um der Problematik der oberen Totzone zu begegnen, ist es teilweise vorgesehen, dass die Leiteranordnung aus zwei Leitern besteht, wobei ein Leiter den anderen Leiter koaxial umgibt. Solche Koaxialleiter haben den Vorteil einer über ihren geometrischen Verlauf gleichbleibenden Impedanz. Zudem lassen sich solche Leiter auch im Allgemeinen leicht an die Impedanz der der Leiteranordnung nachgeschalteten Elektronik anpassen, die häufig bei 50 Ohm liegt.

Für das freie Ende der Leitervorrichtung ist es im Stand der Technik bekannt, Impedanzanpassungskomponenten, Abschlusswiderstände oder aus unterschiedlichen elektrischen Bauteilen - Widerstände, Kondensatoren, Spulen usw. - bestehende Impedanzanpassungenetzwerke vorzusehen. Hingewiesen sei beispielsweise auf die EP 2 711 673 A1, die DE 100 43 838 A1 oder die EP 2 154 496 A1. Insbesondere in der EP 2 711 673 A1 ist vorgesehen, dass ein Innenleiter durch ein Endstück verlängert wird und dass sich der Abschlusswiderstand in dem als Leiter dienenden Endstück befindet.

Patentschriften US 4,035,748 und US 2010/0007441 A1 offenbaren jeweils ein Impedanzanpassungselement zur Verbindung zweier Koaxialkabel.

Die Elemente zur Impedanzanpassung befinden sich dabei im Bereich des freien Endes der Leitervorrichtung und sind daher auch den Prozessbedingungen ausgesetzt.

Der Erfindung liegt daher die Aufgabe zugrunde, ein Abschlusselement vorzuschlagen, das eine Alternative zum Stand der Technik darstellt.

Das erfindungsgemäße Abschlusselement, bei dem die zuvor hergeleitete und aufgezeigte Aufgabe gelöst ist, ist zunächst und im Wesentlichen dadurch gekennzeichnet, dass zwischen einem ersten Zylinderelement und einem zweiten Zylinderelement mindestens ein Trägerelement angeordnet ist und dass auf dem Trägerelement mindestens eine Impedanzanpassungskomponente angeordnet ist.

Das erste und das zweite Zylinderelement sind im Wesentlichen Zylinderförmig ausgestaltet, wobei der Grundquerschnitt z. B. ein Kreis oder ein Polygon ist. Die Seite mindestens eines Zylinderelements ist in einer Ausgestaltung mit Aussparungen und/oder Ausstülpungen versehen. Insgesamt ergibt sich jedoch ein zylinderartiger Gesamteindruck, wobei Zylinder allgemein derartig verstanden werden kann, dass die Höhe größer als die Erstreckung der Grundfläche ist. In einer Ausgestaltung verfügt mindestens ein Zylinderelement an mindestens einer Stirnseite über einen Fuß mit einem größeren oder kleineren Außenumfang als der Zylinder, der das entsprechende Zylinderelement beschreibt.

Erfindungsgemäß sind das erste und das zweite Zylinderelement elektrisch leitfähig. In einer Ausgestaltung sind das erste und das zweite Zylinderelement elektrisch leitend miteinander verbunden. Ist entsprechend wenigstens das erste Zylinderelement elektrisch leitend mit einem Leiter der Leitervorrichtung verbunden, so werden die elektromagnetischen Signale von dem Leiter auch über die zwei Zylinderelemente übertragen. Alternativ ist nur ein Zylinderelement mit einem Leiter der Leitervorrichtung verbunden.

Stellen die zwei Zylinderelemente im verbauten Zustand eine Verlängerung oder eine Art Endstück des Innenleiters dar, so befindet sich die mindestens eine Impedanzanpassungskomponente auf dem Trägerelement außerhalb dieser Verlängerung und insbesondere auch seitlich zur Längsachse des Innenleiters.

In einer Ausgestaltung ist das Trägerelement als Leiterplatte ausgeführt. Erfindungsgemäß weist das Trägerelement eine Leiterplatte auf.

Die Impedanzanpassungskomponente ist in einer Ausgestaltung zumindest ein elektrisches Bauteil und bildet in einer weiteren Ausgestaltung einen Teil eines Anpassungsnetzwerkes.

Erfindungsgemäss ist ein Becherelement vorgesehen. Das Becherelement weist eine Aussparung zur zumindest teilweisen Aufnahme des ersten Zylinderelements auf. Das Becherelement verfügt über einen sich an die Aussparung anschließenden Innenraum mit einem Innenumfang. Das Trägerelement ist in dem Innenraum des Becherelements angeordnet.

In einer Ausgestaltung ist das Becherelement rotationssymmetrisch ausgestaltet. In einer weiteren Ausgestaltung verfügt das Becherelement über eine durchgehende Aussparung. In einer anderen Ausgestaltung ist der Innenraum des Becherelements im Wesentlichen kreiszylindrischen ausgestaltet.

Erfindungsgemäß ist ein Stopfenelement vorgesehen. Das Stopfenelement weist eine Aussparung zur zumindest teilweisen Aufnahme des zweiten Zylinderelements auf.

In einer Ausgestaltung sind das Becherelement und das Stopfenelement fest miteinander verbunden. Dies erfolgt beispielsweise durch Schweißen, Kleben oder Verschrauben. Dabei wird ein form- und/oder kraftschlüssige Verbindung erzeugt.

Sind Becher- und Stopfenelement fest miteinander verbunden, so schützen sie das Trägerelement und insbesondere die mindestens eine Impedanzanpassungskomponente. Für die Verbindung zwischen der Impedanzanpassungskomponente und den Leitern der Leitervorrichtung sind passende Strukturen vorzusehen.

Weiterhin ergibt sich insgesamt ein kompaktes Abschlusselement, das fertig montiert werden kann und dann nur noch mit der Leitervorrichtung verbunden bzw. fixiert werden muss. Daher wird die Herstellung eines Füllstandmessgerätes deutlich vereinfacht.

In einer Ausgestaltung verfügt das Stopfenelement über einen im Innenraum des Becherelements angeordneten Zentralabschnitt. In einer Ausgestaltung ist das Stopfenelement rotationssymmetrisch ausgeführt. In einer weiteren Ausgestaltung verfügt das Stopfenelement über eine durchgehende Aussparung.

In einer weiteren Ausgestaltung weist das Stopfenelement einen Auflageabschnitt auf, wobei ein Außenumfang des Auflageabschnitts größer als der Innenumfang des Innenraums des Becherelements ist. In einer Ausgestaltung grenzt der Auflageabschnitt an den Zentralabschnitt an.

In einer Ausgestaltung ist die Impedanzanpassungskomponente auf der von dem Stopfenelement abgewandten Seite des Trägerelements angeordnet. Dadurch befindet sich die Impedanzanpassungskomponente zwischen dem Boden des Becherelements und dem Trägerelement. Oberhalb des Trägerelements befindet sich zudem noch das Stopfenelement. Die Impedanzanpassungskomponente befindet sich vorzugsweise außerhalb der Zylinderelemente und überdies vorzugsweise bedingt durch die Ausgestaltung und Anordnung des Trägerelements seitlich zu den Zylinderelementen angeordnet.

In einer Ausgestaltung ist vorgesehen, dass das erste Zylinderelement mindestens eine Sacklochbohrung aufweist. In einer alternativen oder ergänzenden Ausgestaltung ist vorgesehen, dass das zweite Zylinderelement mindestens eine Sacklochbohrung aufweist.

Eine Ausgestaltung besteht darin, dass zwischen dem ersten Zylinderelement und dem Becherelement eine Aussparung für mindestens ein Dichtelement vorgesehen ist. Bei dem Dichtelement handelt es sich beispielweise um einen O-Ring. Eine ergänzende oder alternative Ausgestaltung besteht darin, dass zwischen dem zweiten Zylinderelement und dem Stopfenelement mindestens eine Aussparung für mindestens ein Dichtelement vorgesehen ist.

Bei den beiden Ausgestaltungen ist jeweils mindestens eine Aussparung zur Aufnahme mindestens eines Dichtelements vorgesehen. Dabei wird durch das Dichtelement der Übergang zwischen einem Zylinderelement und dem jeweils umgebenden Bauteil - also Becherelement bzw. Stopfenelement - abgedichtet.

In einer Ausgestaltung sind das erste Zylinderelement und das zweite Zylinderelement zueinander fluchtend und spiegelsymmetrisch zum Trägerelement angeordnet.

Gemäß einer weiteren Lehre bezieht sich die Erfindung auf ein nach dem Laufzeit-Verfahren arbeitendes Füllstandmessgerät mit einer mindestens aus einem Außenleiter und einem Innenleiter gebildeten Leitervorrichtung zum Führen von elektromagnetischen Signalen, das zumindest dadurch gekennzeichnet ist, dass an einem freien Ende der Leitervorrichtung ein Abschlusselement nach einem der oben ausgeführten Ausgestaltungen angeordnet ist.

In einer Ausgestaltung ist vorgesehen, dass das erste Zylinderelement über ein Stiftelement elektrisch mit dem Innenleiter kontaktiert ist. Weiterhin ist das zweite Zylinderelement über ein Befestigungselement mit einem Fixierelement verbunden ist. Zudem ist das Fixierelement über mindestens ein weiteres Befestigungselement mit dem Außenleiter verbunden. Für die Impedanzanpassung ist schließlich die Impedanzanpassungskomponente elektrisch mit dem Innenleiter und dem Außenleiter kontaktiert.

In einer Ausgestaltung ist das Fixierelement über zwei Befestigungselemente, bei denen es sich beispielsweise um Schrauben handelt, mit dem Außenleiter verbunden.

Das Fixierelement ist in einer Ausgestaltung streifen- oder balkenähnlich ausgestaltet und ist alternativ im Wesentlichen tellerartig ausgeführt.

In einer Ausgestaltung ist der Außenleiter im Bereich des freien Endes zumindest teilweise in Richtung des Abschlusselements geneigt.

Im Einzelnen gibt es eine Vielzahl von Möglichkeiten, das erfindungsgemäße Abschlusselement und das erfindungsgemäße Füllstandmessgerät auszugestalten und weiterzubilden. Dazu wird verwiesen einerseits auf die den Patentansprüchen 1 und 7 nachgeordneten Patentansprüche, andererseits auf die folgende Beschreibung von Ausführungsbeispielen in Verbindung mit der Zeichnung. In der Zeichnung zeigen
- Fig. 1: einen Schnitt durch eine schematische Darstellung eines Füllstandmessgerätes,
- Fig. 2: einen Schnitt durch ein schematisch dargestelltes Abschlusselement in einer ersten Variante,
- Fig. 3: einen Schnitt durch ein Abschlusselement in einer zweiten Variante,
- Fig. 4: eine räumliche Darstellung eines Teils des in der Fig. 3 dargestellten Abschlusselements und
- Fig. 5: einen Schnitt durch einen vergrößerten Ausschnitt eines Füllstandmessgerätes.

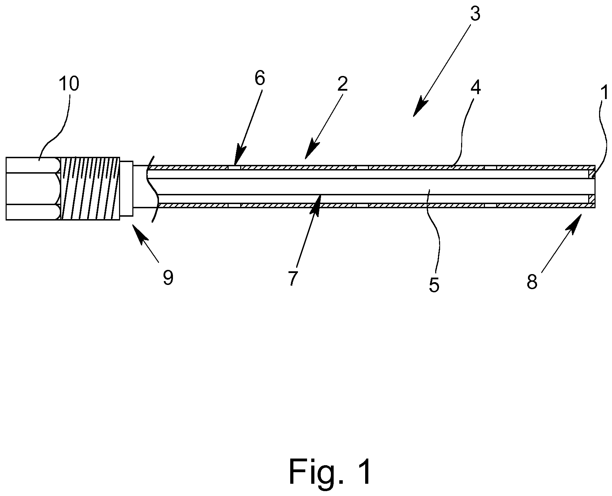

In der Fig. 1 ist ein Abschlusselement 1 für die Leitervorrichtung 2 eines Füllstandmessgeräts 3 dargestellt.

Die Füllstandmessung erfolgt durch die Auswertung der Laufzeit von elektromagnetischen Signalen, die sich entlang der Leitervorrichtung 2 ausbreiten. Dabei umgibt ein Außenleiter 4 koaxial einen Innenleiter 5.

In dem Außenleiter 4 sind Löcher 6 vorhanden, durch die das Medium in den Hohlraum 7 um den Innenleiter 5 herum eindringen kann.

In der Anwendung ist üblicherweise das freie Ende 8 dem - hier nicht dargestellten - Medium zugewandt. An dem gegenüberliegenden Befestigungsende 9 ist ein Anschluss 10 zur Befestigung beispielsweise an der Wandung des das Medium umfassenden Behälters vorgesehen.

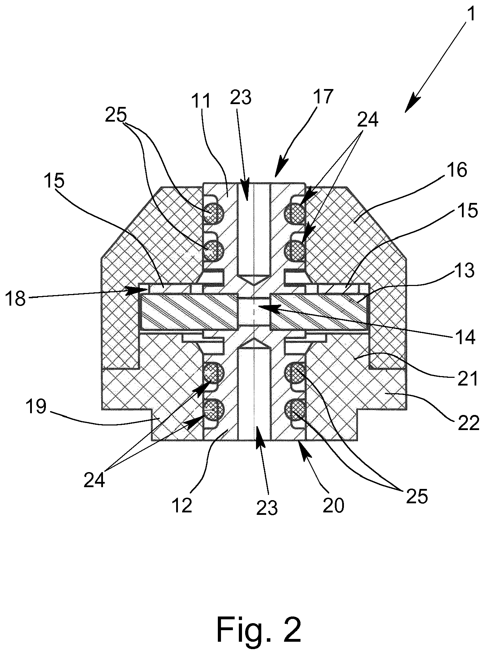

Die Fig. 2 zeigt einen Schnitt durch ein Abschlusselement 1 gemäß einer ersten Ausgestaltung.

Mittig sind das erste Zylinderelement 11 und das zweite Zylinderelement 12 fluchtend zueinander angeordnet und stellen im eingebauten Zustand insbesondere eine Verlängerung des Innenleiters dar. Zwischen beiden befindet sich das Trägerelement 13, in dessen Mitte eine Öffnung 14 vorhanden ist und zu dem die zwei Zylinderelement 11, 12 spiegelsymmetrisch angeordnet sind.

Die Zylinderelemente 11, 12 erstrecken sich hier längs der Längsachse des Abschlusselements 1.

Auf dem Trägerelement 13 befinden sich zwei Impedanzanpassungskomponenten 15, die der Impedanzanpassung von Außen- und Innenleiter dienen.

Das Trägerelement 13 befindet sich innerhalb eines Becherelements 16, das über eine durchgehende Aussparung 17 sowie einen sich daran anschließenden Innenraum 18 verfügt. Der Innenraum 18 ist dabei im Wesentlichen als kreisförmiger Hohlzylinder ausgestaltet, wobei sich zwischen dem Boden des Becherelements 16 und dem Trägerelement 13 die Impedanzanpassungskomponenten 15 befinden. Die Impedanzanpassungskomponenten 15 sind damit auch seitlich zur Längsachse des Abschlusselements 1 angeordnet.

Abgedeckt bzw. verschlossen wird das Becherelement 16 durch ein Stopfenelement 19, das über eine Aussparung 20 für das zweite Zylinderelement 12 verfügt und das über einen Zentralabschnitt 21 in dem Becherelement 16 steckt.

Angrenzend an den Zentralabschnitt 21 ist ein Auflageabschnitt 22 vorgesehen, dessen Außendurchmesser dem Außendurchmesser des an ihn angrenzenden Becherelements 16 entspricht und daher bündig mit ihm abschließt.

Im Bereich des Auflageabschnitts 22 ist das Stopfenelement 19 mit dem Becherelement 16 mittels Laserschweißung verschweißt. Daher bildet das Abschlusselement 1 eine kompakte und in sich geschlossene Einheit, die nur noch in die Leitervorrichtung eines Füllstandmessgeräts eingebracht werden muss.

An den Auflageabschnitt 22 des Stopfenelements 19 grenzt hier noch eine Erhöhung an.

Mittig in den Zylinderelementen 11, 12 ist jeweils eine Sacklochbohrung 23 vorgesehen, die hier jeweils über ein Innengewinde verfügen.

Um den Übergang zwischen den Zylinderelementen 11, 12 und dem Becherelement 16 bzw. dem Stopfenelement 19 abzudichten, verfügen beide Zylinderelemente 11, 12 an ihren Seiten jeweils über zwei kreisförmig umlaufende Aussparungen 24, in denen jeweils ein O-Ring als Dichtelement 25 vorgesehen ist.

In Bezug auf die Materialauswahl bestehen die Zylinderelemente 11, 12 hier aus Stahl - bzw. allgemein aus einem elektrisch leitfähigen Material - und das Becherelement 16 und das Stopfenelement 19 jeweils aus einem Polyetheretherketon (PEEK) als einem Beispiel für ein elektrisch isolierendes Material.

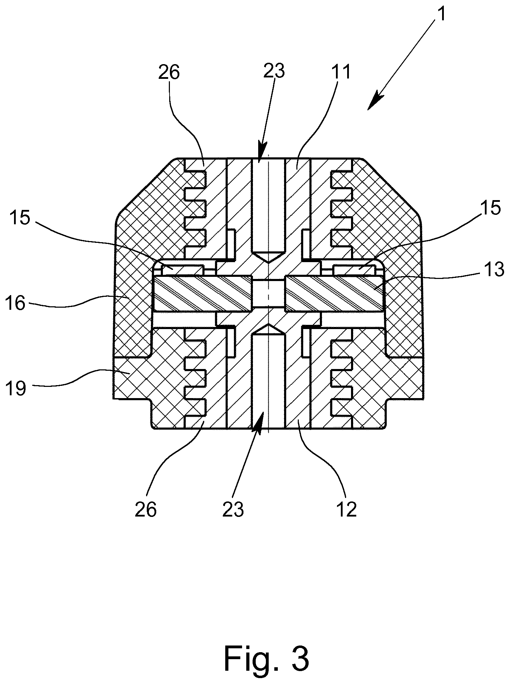

In der Fig. 3 ist eine weitere Variante des Abschlusselements 1 dargestellt, das sehr ähnlich der in der Fig. 2 dargestellten Variante ist. Daher wird auf die Beschreibung der identischen Elemente verzichtet.

Die Zylinderelemente 11, 12 sind hier frei von seitlichen Aussparungen und sind stattdessen jeweils von einem Halteelement 26 umgeben und mit diesem durch Laserschweißung verbunden. Die Halteelemente 26 haben innen eine durchgehend kreiszylindrische Form und verfügen außen über eine sich abwechselnde Struktur aus Vorsprüngen und Aussparungen. Dabei sind die Halteelemente 26 rotationssymmetrisch ausgestaltet und passend in das Becherelement 16 bzw. das Stopfenelement 19 eingefügt.

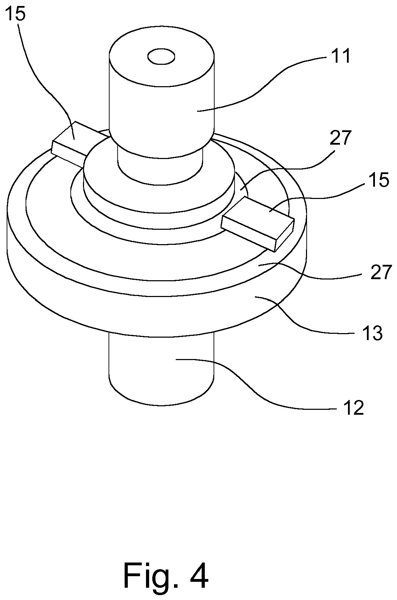

Die Fig. 4 zeigt die zwei Zylinderelement 11, 12 und das Trägerelement 13 des Abschlusselements 1 der Fig. 3.

Zu erkennen ist hier am ersten Zylinderelement 11 der Fuß unterhalb der Verengung, die sich an den hier glatt verlaufenden Außenzylinderabsatz anschließt.

Das ringförmige Trägerelement 13 umfasst an der Außen- und der Innenberandung jeweils eine Kontaktfläche 27, mit der die beiden Impedanzanpassungskomponenten 15 elektrisch leitend verbunden sind.

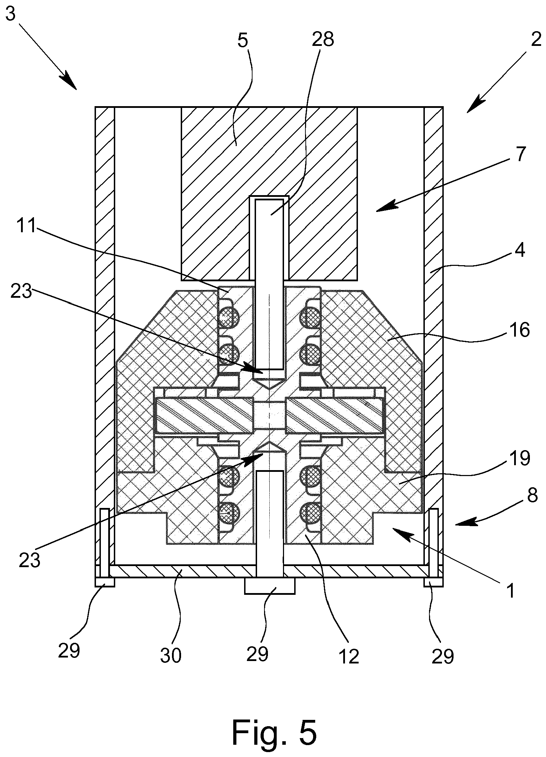

In der Fig. 5 ist dargestellt, wie ein Abschlusselement 1 mit einer Leitervorrichtung 2 verbunden ist.

In der Sacklochbohrung 23 des ersten Zylinderelements 11 befindet sich ein Stiftelement 28, das einer elektrischen Kontaktierung des Innenleiters 5 dient.

In der Sacklochbohrung 23 des zweiten Zylinderelements 12 ist ein Befestigungselement 29 in Form einer Schraube vorgesehen, wobei sich zwischen dem Abschlusselement 1 und dem Befestigungselement 29 ein Fixierelement 30 in Form eines Balkens befindet. Das Fixierelement 30 erstreckt sich seitlich bis zum Außenleiter 4, wo zwei weitere Befestigungselemente 29 eine Fixierung realisieren.

Die zwei Zylinderelement 11, 12 sind in der dargestellten Variante eine Verlängerung des Innenleiters 5, wobei sich die Impedanzanpassungskomponenten außerhalb dieser Verlängerung und hier sogar senkrecht zur Längsachse befinden.

## Patentansprüche

1. Abschlusselement (1) für eine Leitervorrichtung (2) eines nach dem Laufzeit-Verfahren arbeitenden Füllstandmessgeräts (3),
wobei zwischen einem elektrisch leitfähigen ersten Zylinderelement (11) und einem elektrisch leitfähigen zweiten Zylinderelement (12) mindestens ein Trägerelement (13) angeordnet ist, wobei auf dem Trägerelement (13) mindestens eine Impedanzanpassungskomponente (15) angeordnet ist, wobei das Trägerelement (13) eine Leiterplatte aufweist,
**dadurch gekennzeichnet,**
**dass** ein Becherelement (16) vorgesehen ist, dass das Becherelement (16) eine Aussparung (17) zur zumindest teilweisen Aufnahme des ersten Zylinderelements (11) aufweist, dass das Becherelement (16) über einen sich an die Aussparung (17) anschließenden Innenraum (18) mit einem Innenumfang verfügt und dass das Trägerelement (13) in dem Innenraum (18) des Becherelements (16) angeordnet ist und dass ein Stopfenelement (19) vorgesehen ist und dass das Stopfenelement (19) eine Aussparung (20) zur zumindest teilweisen Aufnahme des zweiten Zylinderelements (12) aufweist.

2. Abschlusselement (1) nach Anspruch 1, **dadurch gekennzeichnet, dass** das Stopfenelement (19) einen im Innenraum (18) des Becherelements (16) angeordneten Zentralabschnitt (21) aufweist und dass das Stopfenelement (19) einen Auflageabschnitt (22) aufweist, wobei ein Außenumfang des Auflageabschnitts (22) größer als der Innenumfang des Innenraums (18) des Becherelements (16) ist.

3. Abschlusselement (1) nach Anspruch 1 oder 2, **dadurch gekennzeichnet, dass** zwischen dem ersten Zylinderelement (11) und dem Becherelement (16) und/oder zwischen dem zweiten Zylinderelement (12) und dem Stopfenelement (19) mindestens eine Aussparung (24) für mindestens ein Dichtelement (25) vorgesehen ist.

4. Abschlusselement (1) nach einem der Ansprüche 1 bis 3, **dadurch gekennzeichnet, dass** die Impedanzanpassungskomponente (15) auf der von dem Stopfenelement (19) abgewandten Seite des Trägerelements (13) angeordnet ist.

5. Abschlusselement (1) nach einem der Ansprüche 1 bis 4, **dadurch gekennzeichnet, dass** das erste Zylinderelement (11) und/oder das zweite Zylinderelement (12) mindestens eine Sacklochbohrung (23) aufweisen/aufweist.

6. Abschlusselement (1) nach einem der Ansprüche 1 bis 5, **dadurch gekennzeichnet, dass** das erste Zylinderelement (11) und das zweite Zylinderelement (12) zueinander fluchtend und spiegelsymmetrisch zum Trägerelement (13) angeordnet sind.

7. Nach dem Laufzeit-Verfahren arbeitendes Füllstandmessgerät (3) mit einer mindestens aus einem Außenleiter (4) und einem Innenleiter (5) gebildeten Leitervorrichtung (2) zum Führen von elektromagnetischen Signalen,
**dadurch gekennzeichnet,**
**dass** an einem freien Ende (8) der Leitervorrichtung (2) ein Abschlusselement (1) nach einem der Ansprüche 1 bis 6 angeordnet ist.

8. Füllstandmessgerät (3) nach Anspruch 7, **dadurch gekennzeichnet, dass** das erste Zylinderelement (11) über ein Stiftelement (28) elektrisch mit dem Innenleiter (5) kontaktiert ist, dass das zweite Zylinderelement (12) über ein Befestigungselement (29) mit einem Fixierelement (30) verbunden ist, dass das Fixierelement (30) über mindestens ein weiteres Befestigungselement (29) mit dem Außenleiter (4) verbunden ist und dass die Impedanzanpassungskomponente (15) elektrisch mit dem Innenleiter (5) und dem Außenleiter (4) kontaktiert ist.

## Claims

1. Termination element (1) for a conductor device (2) of a fill level measuring device (3) operating according to the transit time method,
wherein at least one carrier element (13) is arranged between an electrically conductive first cylinder element (11) and an electrically conductive second cylinder element (12), wherein at least one impedance matching component (15) is arranged on the carrier element (13), wherein the carrier element (13) has a printed circuit board,
**characterized in**
**that** a cup element (16) is provided, that the cup element (16) has a recess (17) for at least partially receiving the first cylinder element (11), that the cup element (16) has an internal space (18) which adjoins the recess (17) and has an inner circumference, and that the carrier element (13) is arranged in the internal space (18) of the cup element (16), and that a plug element (19) is provided, and that the plug element (19) has a recess (20) for at least partially receiving the second cylinder element (12).

2. Termination element (1) according to claim 1, **characterized in that** the plug element (19) has a central section (21) arranged in the interior (18) of the cup element (16) and **in that** the plug element (19) has a support section (22), an outer circumference of the support section (22) being larger than the inner circumference of the interior (18) of the cup element (16).

3. Termination element (1) according to claim 1 or 2, **characterized in that** at least one recess (24) for at least one sealing element (25) is provided between the first cylinder element (11) and the cup element (16) and/or between the second cylinder element (12) and the plug element (19).

4. Termination element (1) according to any one of claims 1 to 3, **characterized in that** the impedance matching component (15) is arranged on the side of the carrier element (13) facing away from the plug element (19).

5. Termination element (1) according to any one of claims 1 to 4, **characterized in that** the first cylinder element (11) and/or the second cylinder element (12) has/have at least one blind bore (23).

6. Termination element (1) according to any one of claims 1 to 5, **characterized in that** the first cylinder element (11) and the second cylinder element (12) are arranged in alignment with one another and mirror-symmetrically with respect to the carrier element (13).

7. Fill level measuring device (3) operating according to the transit time method, having a conductor device (2), formed at least from an outer conductor (4) and an inner conductor (5), for guiding electromagnetic signals,
**characterized in**
**that** a termination element (1) according to any one of claims 1 to 6 is arranged at a free end (8) of the conductor device (2).

8. Fill level measuring device (3) according to claim 7, **characterized in that** the first cylinder element (11) is electrically contacted with the inner conductor (5) via a pin element (28), **in that** the second cylinder element (12) is connected with a fixing element (30) via a fastening element (29), **in that** the fixing element (30) is connected with the outer conductor (4) via at least one further fastening element (29) and **in that** the impedance matching component (15) is electrically contacted with the inner conductor (5) and the outer conductor (4).

## Revendications

1. Élément de terminaison (1) destiné à un dispositif conducteur (2) d'une unité de mesure de niveau de remplissage (3) fonctionnant selon le procédé du temps de propagation, au moins un élément de support (13) étant disposé entre un premier élément cylindrique électriquement conducteur (11) et un deuxième élément cylindrique électriquement conducteur (12), au moins un composant d'adaptation d'impédance (15) étant disposé sur l'élément de support (13), l'élément de support (13) comportant une carte de circuit imprimé,
**caractérisé en ce qu'**il est prévu un élément formant godet (16), **en ce que** l'élément formant godet (16) comporte un évidement (17) destiné à recevoir au moins partiellement le premier élément cylindrique (11), **en ce que** l'élément formant godet (16) dispose d'un espace intérieur (18) adjacent à l'évidement (17) et présentant une périphérie intérieure et **en ce que** l'élément de support (13) est disposé dans l'espace intérieur (18) de l'élément formant godet (16) et **en ce qu'**un élément formant bouchon (19) est prévu et **en ce que** l'élément formant bouchon (19) comporte un évidement (20) destiné à recevoir au moins partiellement le deuxième élément cylindrique (12).

2. Élément de terminaison (1) selon la revendication 1, **caractérisé en ce que** l'élément formant bouchon (19) comporte une partie centrale (21) disposée dans l'espace intérieur (18) de l'élément formant godet (16) et **en ce que** l'élément formant bouchon (19) comporte une partie d'appui (22), une périphérie extérieure de la partie d'appui (22) étant plus grande que la périphérie intérieure de l'espace intérieur (18) de l'élément formant godet (16).

3. Élément de terminaison (1) selon la revendication 1 ou 2, **caractérisé en ce qu'**au moins un évidement (24) destiné à au moins un élément d'étanchéité (25) est ménagé entre le premier élément cylindrique (11) et l'élément formant godet (16) et/ou entre le deuxième élément cylindrique (12) et l'élément de bouchon (19).

4. Élément de terminaison (1) selon l'une des revendications 1 à 3, **caractérisé en ce que** le composant d'adaptation d'impédance (15) est disposé du côté de l'élément de support (13) qui est opposé à l'élément formant bouchon (19).

5. Élément de terminaison (1) selon l'une des revendications 1 à 4, **caractérisé en ce que** le premier élément cylindrique (11) et/ou le deuxième élément cylindrique (12) comportent au moins un trou borgne (23) .

6. Élément de fermeture (1) selon l'une des revendications 1 à 5, **caractérisé en ce que** le premier élément cylindrique (11) et le deuxième élément cylindrique (12) sont disposés en alignement l'un avec l'autre et en symétrie de miroir par rapport à l'élément de support (13).

7. Unité de mesure de niveau de remplissage (3), fonctionnant selon le principe du temps de propagation, comprenant un dispositif conducteur (2) formé d'au moins un conducteur extérieur (4) et d'un conducteur intérieur (5) et destiné à guider des signaux électromagnétiques,
**caractérisée en ce que**
un élément de terminaison (1) selon l'une des revendications 1 à 6 est disposé à une extrémité libre (8) du dispositif conducteur (2).

8. Unité de mesure de niveau de remplissage (3) selon la revendication 7, **caractérisée en ce que** le premier élément cylindrique (11) est mis en contact électrique avec le conducteur intérieur (5) par le biais d'un élément formant tige (28), **en ce que** le deuxième élément cylindrique (12) est relié à un élément fixateur (30) par un élément de fixation (29), **en ce que** l'élément fixateur (30) est relié au conducteur extérieur (4) par le biais d'au moins un autre élément de fixation (29) et **en ce que** le composant d'adaptation d'impédance (15) est mis en contact électrique avec le conducteur intérieur (5) et le conducteur extérieur (4) .
